# EUROPÄISCHE PATENTSCHRIFT

(11) **EP 3 620 802 B1**
(45) Veröffentlichungstag und Bekanntmachung des Hinweises auf die Patenterteilung: **15.05.2024**
(21) Anmeldenummer: 19195040.1
(22) Anmeldetag: 03.09.2019
(51) Int. Cl.: G01R 27/26, H03K 17/955

(54) **ANORDNUNG FÜR EINE DETEKTION BEI EINEM TÜRGRIFF EINES FAHRZEUGES**
ARRANGEMENT FOR DETECTION IN A DOOR HANDLE OF A VEHICLE
AGENCEMENT DE DÉTECTION DANS UNE POIGNÉE DE PORTE D'UN VÉHICULE

(30) Priorität: 04.09.2018 DE 102018121521
(43) Veröffentlichungstag der Anmeldung: 11.03.2020
(73) Patentinhaber: Huf Hülsbeck & Fürst GmbH & Co. KG, 42551 Velbert (DE)
(72) Erfinder: Gornik, Andreas, 58285 Gevelsberg (DE); Bextermöller, Hubert, 45468 Mülheim a.d.R. (DE); Sieg, Berthold, 46240 Bottrop (DE); Peschl, Andreas, 42555 Velbert (DE)
(74) Vertreter: Bals & Vogel Patentanwälte PartGmbB

(56) Entgegenhaltungen:
- DE-A1-102012 224 007
- US-A1- 2008 116 904
- US-A1- 2015 070 300

## Beschreibung

Die vorliegende Erfindung betrifft eine Anordnung für eine Detektion bei einem Türgriff eines Fahrzeuges. Ferner bezieht sich die Erfindung auf ein Verfahren für eine Detektion bei einem Türgriff eines Fahrzeuges.

Es ist aus dem Stand der Technik bekannt, dass mittels eines Sensorelements, wie einer Sensorelektrode, Veränderungen in einer Umgebung des Sensorelements erfasst werden können. Hierzu kann das Sensorelement eine veränderliche Kapazität bereitstellen, welche für diese Veränderungen in der Umgebung spezifisch ist. In anderen Worten kann durch eine Erfassung der Veränderung dieser Kapazität detektiert werden, dass eine Annäherung oder eine Geste oder dergleichen in der Umgebung erfolgt. Diese Detektion wird bspw. genutzt, um Funktionen des Fahrzeuges zu aktiveren. Solche Funktionen können das Öffnen einer Heckklappe oder das Entriegeln von Fahrzeugtüren sein.

Die Auswertung des Sensorelements durch eine Elektronik des Fahrzeuges kann dadurch erfolgen, dass Ladungsübertragungen von dem Sensorelement zur Elektronik durchgeführt werden. Zur Auswertung dieser Ladungsübertragungen sind diverse Methoden bekannt, welche auf einer Auswertung der hierdurch übertragenen Ladungsmengen basieren. Hierzu kann z. B. die Ladungsmenge auf einen Haltekondensator übertragen werden, und die entsprechend beeinflusste Spannung am Haltekondensator mittels eines Analog-Digital-Wandlers erfasst werden. Der Ladezustand am Haltekondensator wird somit direkt anhand des gemessenen Spannungswerts ermittelt und für die Detektion berücksichtigt.

Allerdings ist eine derartige Ermittlung des Ladezustands des Haltekondensators mit einem höheren technischen Aufwand verbunden. Insbesondere wenn nur geringfügige Veränderungen des Ladezustands durch die Veränderung in der Umgebung bewirkt werden, ist die Verwendung eines Analog-Digital-Wandlers mit einer daran angepassten höheren Auflösung notwendig. Entsprechend ist beim Einsatz von günstigeren Analog-Digital-Wandlern der Nachteil, dass die Sensitivität und die Geschwindigkeit der Erfassung verschlechtert wird.

Relevanter Stand der Technik wird in US 2008/116904 A1, US 2015/070300 A1 und DE 10 2012 224007 A1 offenbart.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte Möglichkeit zur Ermittlung des Ladezustands bereitzustellen.

Die voranstehende Aufgabe wird gelöst durch eine Anordnung mit den Merkmalen des unabhängigen Vorrichtungsanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Anordnung, vorzugsweise elektronische Schaltungsanordnung, für eine Detektion bei einem Türgriff eines Fahrzeuges. Bevorzugt dient dabei die erfindungsgemäße Anordnung zur Detektion einer Aktivierungshandlung beim Türgriff, um bei erfolgreicher Detektion bspw. einen Steuerbefehl beim Fahrzeug zu erzeugen. Der Türgriff ist bspw. ein Außentürgriff einer Seitentür oder einer Front- oder Heckklappe des Fahrzeuges. Der Steuerbefehl ist z. B. eine Entriegelung oder die Initiierung einer Öffnungsbewegung der Seitentür, Front- oder Heckklappe. Hierzu kann die Anordnung (insbesondere vollständig) in dem Türgriff integriert und/oder von einem Türgriffgehäuse umgeben und/oder vergossen sein.

Die Anordnung weist wenigstens eines der nachfolgenden elektrischen und/oder elektronischen Komponenten auf:
- wenigstens ein Sensorelement zur Erfassung einer Veränderung in einer Umgebung des Sensorelements, bevorzugt derart im Türgriff angeordnet, dass ein vorgegebener Bereich der Umgebung außerhalb des Türgriffs in Abhängigkeit von dieser Anordnung erfasst wird,
- eine Kontrollvorrichtung zur wiederholten Ermittlung wenigstens eines für die Erfassung spezifischen Parameters des Sensorelements, wie eine Sensorkapazität, um die Detektion bei dem Türgriff durchzuführen,
- eine elektrische Halteanordnung, welche zur wiederholten Ladungsübertragung mit dem wenigstens einen Sensorelement verschaltet ist, um anhand eines dadurch (durch die einzelne Ladungsübertragung oder mehrere Ladungsübertragungen) veränderten Ladezustands (insbesondere Ladezustandsveränderung) der Halteanordnung, den Parameter zu ermitteln.

Die Komponenten einer erfindungsgemäßen Anordnung können zur Bereitstellung der im Zusammenhang mit den jeweiligen Komponenten beschriebenen Funktionalität miteinander verschaltet, insbesondere elektrisch verbunden sein, z. B. über Leiterbahnen einer Leiterplatte der erfindungsgemäßen Anordnung. Die Kontrollvorrichtung kann bspw. als eine Ansteuerungsvorrichtung wie ein Mikrocontroller oder dergleichen ausgebildet sein oder wenigstens eine Ansteuerungsvorrichtung aufweisen. Die elektrische Halteanordnung kann in der Kontrollvorrichtung und/oder in der Ansteuerungsvorrichtung integriert sein (z. B. als Teil der Peripherie des Mikrocontrollers, wie ein Haltekondensator eines Analog-Digital-Wandlers) oder extern von der Kontrollvorrichtung bzw. Ansteuerungsvorrichtung z. B. mit wenigstens einem diskreten Bauelement vorgesehen sein.

Hierbei ist insbesondere vorgesehen, dass (vorzugsweise zur Auswertung des Ladezustands, insbesondere Auswertung einer Veränderung des Ladezustands) eine (elektrische und/oder elektronische) Zeiterfassungsanordnung der Kontrollvorrichtung mit der Halteanordnung verschaltet ist, um zur Ermittlung des (insbesondere jeweils nach der Ladungsübertragung vorliegenden jeweils einzelnen) Ladezustands die Halteanordnung zeitlich auszuwerten. Dies hat den Vorteil, dass durch die zeitliche Ermittlung des Ladezustands die zeitliche Auflösung der Zeiterfassungsanordnung für die Geschwindigkeit und Sensitivität der Ermittlung maßgeblich sein kann. Es kommt also nicht auf die Auflösung einer Messeinheit (wie eines Analog-Digital-Wandlers) an, mit welcher eine Spannung oder dergleichen in einem einzigen Zeitpunkt (z. B. direkt) erfasst werden kann. Stattdessen wird nicht die Spannung oder der Ladezustand direkt quantitativ gemessen, sondern indirekt eine davon abhängige Zeit. In anderen Worten erfolgt die Ermittlung eines einzigen Ladezustands zu einem bestimmten Zeitpunkt also nicht in diesem Zeitpunkt, sondern es wird die zeitliche Auswertung in einem anschließenden Zeitbereich durchgeführt, um den Ladezustand zu diesem bestimmten Zeitpunkt zu ermitteln. Eine dafür genutztes Zeiteinheit (Zeitmesseinheit) kann technisch einfacher und kostengünstiger so ausgeführt sein, dass eine präzise und schnelle Erfassung möglich ist.

Die Zeiterfassungsanordnung kann zumindest teilweise in der Ansteuerungsvorrichtung integriert sein oder vollständig extern davon ausgebildet sein. Bevorzugt ist dabei die Zeiterfassungsanordnung als eine Verschaltung von Elektronikkomponenten ausgebildet, wie eines Komparators als Vergleichseinheit und/oder eines Timers als Zeiteinheit.

Insbesondere erfolgt das zeitliche Auswerten des Ladezustands dadurch, dass eine aus der Ladungsübertragung resultierende Spannung mittels einer Zeiteinheit der Zeiterfassungsanordnung und insbesondere mittels einer Anordnung aus Widerstand (Widerstandseinheit) und Kondensator (insbesondere Haltekondensator der Halteanordnung) gemessen wird. So kann der Ladezustand herkömmlicherweise durch die Messung einer Messspannung über den Haltekondensator der Halteanordnung durch einen Analog-Digital-Wandler (A/D-Wandler) ermittelt werden, um proportional zur Messspannung die von dem Sensorelement (Sensorelektrode) übertragene Ladungsmenge zu bestimmen. Auf diese Weise kann eine veränderliche Sensorkapazität bzw. eine Kapazitätsveränderung detektiert werden. Wenn allerdings die Auflösung des A/D-Wandlers zu niedrig ist, können geringfügige Kapazitätsänderungen bzw. signifikante Kapazitätsveränderungen nicht schnell genug festgestellt werden. Erfindungsgemäß kann daher ein hierzu unterschiedliches Messverfahren durch eine zeitliche Auswertung genutzt werden. Kapazitätsveränderungen können damit verbessert detektiert werden.

Um die zeitliche Auswertung durchführen zu können, wird der Haltekondensator der Halteanordnung z. B. über ein Widerstandselement (als Entladewiderstand) entladen. Die Auswertung kann nun eine Zeitspanne ermitteln, bis durch die Spannung an diesem Widerstandselement ein Schwellenwert erreicht wird. Diese Zeitspannung ist umso länger, je höher der Ladezustand des Haltekondensators vor der Entladung des Haltekondensators war. In anderen Worten kann durch die zeitliche Auswertung eine Lade- und/oder Entladekurve des Haltekondensators ausgewertet werden. Durch den Entladewiderstand kann dabei die Zeitdauer beim Entladen beeinflusst werden.

Ein Analog-Digital-Wandler der Kontrollvorrichtung kann z. B. eine 5 Bit oder eine 10 Bit Auflösung aufweisen. Ein Digital-Analog-Wandler der Kontrollvorrichtung ist bspw. mit einer Auflösung im Bereich von 2 bis 6 Bit ausgeführt. Außerdem kann ein 8 oder 16 Bit Timer der Kontrollvorrichtung als Zeiteinheit vorgesehen sein.

Vorteilhaft ist es im Rahmen der Erfindung, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semi-autonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Aktivierungshandlung, wie einer Annäherung oder Geste eines Benutzers, die Funktion aktiviert, z. B. eine Fahrzeugbeleuchtung aktiviert und/oder die Klappe betätigt und/oder die Entriegelung durchgeführt.

Vorteilhafterweise ist die kapazitive Sensorvorrichtung in einen Türgriff des Fahrzeuges integriert. In diesem Fall kann die Detektion der Aktivierungshandlung, wie eine Annäherung an den Türgriff, z. B. das Entriegeln oder das Öffnen einer Tür oder Klappe des Fahrzeuges bewirken.

Es ist möglich, dass die Ladungsübertragungen jeweils dadurch durchgeführt werden, dass einzelne oder wiederholte elektrische Pulse zwischen einer (zur Ansteuerungsvorrichtung externen oder internen) Halteanordnung und dem Sensorelement initiiert werden. Hierzu kann z. B. wenigstens eine elektrische Schalteinheit genutzt werden, welche mit einem Übertragungspfad zwischen der Halteanordnung und dem Sensorelement verbunden oder darin integriert ist. Ferner kann auch eine Ansteuerungsvorrichtung vorgesehen sein, welche ggf. auch eine Verarbeitungsvorrichtung zur Daten- und/oder Signalverarbeitung ausbildet. Die Ansteuerungsvorrichtung kann bspw. mit der wenigstens einen Schalteinheit elektrisch verbunden sein, um diese zur Ladungsübertragung anzusteuern. Bspw. ist die Ansteuerungsvorrichtung als Mikrocontroller oder als Teil eines Mikrocontrollers ausgebildet, welche die Ansteuerung vornimmt. Auch kann als Ansteuerungsvorrichtung ggf. zumindest ein Teil eines Computerprogramms aufgefasst werden oder ein Computerprogramm als Anpassungsmittel aufweisen, welches bspw. durch einen Mikrocontroller bzw. die Kontrollvorrichtung bzw. die Ansteuerungsvorrichtung ausgeführt wird.

Es kann vorgesehen sein, dass der Ladezustand der Halteanordnung die Ladungsmenge betrifft, welche durch wenigstens einen Haltekondensator der Halteanordnung gespeichert ist, und/oder proportional zu einer elektrischen Spannung über dem Haltekondensator ist.

Um den Ladezustand zu ermitteln, kann somit (z. B. für jede Ermittlung des Parameters) eine zeitliche Spannungsveränderung an dem Haltekondensator ausgewertet werden, z. B. mittels der Zeiterfassungsanordnung.

Ferner kann es im Rahmen der Erfindung vorgesehen sein, dass der Parameter eine veränderliche Sensorkapazität ist oder betrifft, welche durch das Sensorelement bereitgestellt ist. Bevorzugt kann eine Ansteuerungsvorrichtung vorgesehen sein, um anhand des Ladezustands, insbesondere einer zeitlichen Spannungsveränderung an der Halteanordnung, nach einer vorgegebenen oder variablen Anzahl der Ladungsübertragungen die Sensorkapazität oder einen davon abhängigen Parameter zu bestimmen.

Ferner kann ggf. das Sensorelement als eine Sensorelektrode ausgebildet sein, welche vorzugsweise in Wechselwirkung mit einem Massepotential des Fahrzeuges eine Art Kondensator ausbildet. Bspw. kann bei diesem Verständnis des Messprinzips die Umgebung der Sensorelektrode die Kapazität des Kondensators beeinflussen, und somit die veränderliche Sensorkapazität bewirken. Bspw. kann eine Zeitdauer mittels der Zeiterfassungsanordnung in eine digitale Information umgewandelt werden, welche durch die Ansteuerungsvorrichtung (als Verarbeitungsvorrichtung) ausgewertet wird. Als Ergebnis der Auswertung kann dann z. B. eine Information über die Sensorkapazität bereitgestellt werden.

Vorteilhaft ist es darüber hinaus, wenn im Rahmen der Erfindung die Zeiterfassungsanordnung zur zeitlichen Auswertung zumindest die oder wenigstens eine der nachfolgenden Komponenten aufweist:
- eine Referenzeinheit zur Erzeugung eines Referenzsignals, insbesondere einer Referenzspannung,
- eine Vergleichseinheit zum Vergleich eines Auswertesignals, insbesondere einer elektrischen Auswertespannung, mit dem Referenzsignal, insbesondere der Referenzspannung, wobei das Auswertesignal, insbesondere die Auswertespannung, und/oder das Referenzsignal für den jeweils nach der Ladungsübertragung vorliegenden Ladezustand der Halteanordnung spezifisch ist, und insbesondere für eine jeweils dann vorliegende elektrische Spannung an der Halteanordnung, bevorzugt an einem Haltekondensator, spezifisch ist,
- eine Zeiteinheit zur Ermittlung einer Zeitdauer in Abhängigkeit von dem Vergleich, wobei eine Verarbeitungsvorrichtung vorgesehen und insbesondere zum Auslesen der Zeitdauer von der Zeiteinheit ausgeführt ist, um die Detektion bei dem Türgriff anhand der Zeitdauer durchzuführen.

Als Auswertesignal wird bspw. eine elektrische Größe verwendet, welches direkt abhängig ist von der Spannung an der Halteanordnung. Dies kann z. B. die Spannung über eine Widerstandseinheit (einen elektrischen Widerstand oder dergleichen) sein, welcher parallel oder seriell zu einem Haltekondensator geschaltet ist. Die Verarbeitungsvorrichtung kann bspw. durch die Ansteuerungsvorrichtung bereitgestellt sein, und ist z. B. als Mikrocontroller oder dergleichen ausgebildet. Die Zeiteinheit kann z. B. zur Messung einer Zeitdauer ausgeführt sein, welche von dem Ergebnis des Vergleichs abhängt (z. B. eine Zeitdauer bis zum Erreichen eines bestimmten Ergebnisses). Da die Zeitdauer bis zum Vorliegen eines bestimmten Ergebnisses mit dem Ladezustand korreliert, kann anhand der Zeitdauer auf den Ladezustand sehr zuverlässig geschlossen werden.

Außerdem ist es von Vorteil, wenn die Zeiterfassungsanordnung zur Erfassung einer vom Ladezustand abhängigen Zeitdauer ausgeführt ist, insbesondere einer Entladezeitdauer oder Aufladezeitdauer eines Haltekondensators der Halteanordnung oder einer Messanordnung, insbesondere eines Messkondensators, in Abhängigkeit von dem Haltekondensator, um hierdurch die Halteanordnung zeitlich auszuwerten. Die Kurve der Auf- oder Entladung hängt dabei vom anfänglichen Ladezustand ab, sodass die unterschiedlichen Ladekurven durch die zeitliche Auswertung identifiziert werden können, um den anfänglichen Ladezustand zu ermitteln. Die Entladezeitdauer oder Aufladezeitdauer der Messanordnung in Abhängigkeit von dem Haltekondensator kann z. B. eine Dauer sein, bis bei einer Ent- bzw. Aufladung der Messanordnung eine Spannung der Messanordnung eine Referenzspannung erreicht, welche durch die Spannung am Haltekondensator bereitgestellt wird.

Ferner kann es im Rahmen der Erfindung vorgesehen sein, dass die Zeiterfassungsanordnung dazu ausgeführt ist, den Ladezustand durch die zeitliche Auswertung dadurch zu ermitteln, dass ein Messvorgang zur Ermittlung des Ladezustands initiiert und zeitlich ausgewertet wird. Der Messvorgang ist bspw. ein Initiieren einer Auf- oder Entladung der Halteanordnung bei gleichzeitiger Initiierung eines Vergleichs einer Vergleichseinheit einer für die Auf- oder Entladung spezifischen Größe.

Ferner ist es denkbar, dass die zeitliche Auswertung des Ladezustands durch eine Ansteuerung der Zeiterfassungsanordnung, vorzugsweise durch ein Aktivieren einer Zeiteinheit und/oder durch ein Aktivieren eines UND-Gatters, welches zwischen einer Vergleichseinheit und der Zeiteinheit verschaltet ist, zur Initiieren der Zeiterfassung, und bevorzugt durch ein Schalten wenigstens einer Initiierungseinheit, besonders bevorzugt als eine der Schalteinheiten, zum Initiieren eines Lade- und/oder Entladevorgangs der Halteanordnung erfolgt. Auf diese Weise wird ein sehr zuverlässiger und technisch wenig komplexer Aufbau zur Auswertung bereitgestellt.

Des Weiteren ist es denkbar, dass eine Ansteuerungsvorrichtung vorgesehen ist, welche insbesondere zum Schalten mehrerer Schalteinheiten ausgeführt ist, um für die jeweilige Ermittlung des Parameters zumindest nachfolgendes zu initiieren:
- eine elektrische Aufladung des Sensorelements, insbesondere durch eine Übertragung von elektrischen Ladungen zum Sensorelement, vorzugsweise durch die Herstellung einer elektrischen Verbindung des Sensorelements mit einer Spannungsquelle,
- eine der wiederholten Ladungsübertragungen zur Halteanordnung, insbesondere durch ein Schalten wenigstens einer der Schalteinheiten, vorzugsweise durch eine Herstellung einer elektrischen Verbindung des Sensorelements mit der Halteanordnung,
- die zeitliche Auswertung zur Ermittlung des nach der Ladungsübertragung vorliegenden Ladezustands der Halteanordnung, vorzugweise zumindest teilweise gleichzeitig mit einer Auf- oder Entladung der Halteanordnung, sodass insbesondere die Auswertung den Auf- oder Entladevorgang überwacht,
- eine erneute elektrische Aufladung des Sensorelements, um insbesondere die genannten Schritte zu wiederholen.

Die Auswertung kann z. B. einen Vergleich mittels einer Vergleichseinheit und ein Zählen mittels einer Zeiteinheit und ein Übertragen des Zählergebnisses nach einem Vorliegen eines bestimmten Ergebnisses der Vergleichseinheit an eine Ansteuerungsvorrichtung umfassen.

Im Rahmen der Erfindung kann unter "verschaltet" auch eine direkte elektrische Verbindung und/oder direkte Signalverbindung verstanden werden. Ferner kann das Vergleichen auch zeitlich wiederholte Vergleiche umfassen, welche z. B. in regelmäßigen zeitlichen Abständen durchgeführt werden.

Gemäß einem weiteren Vorteil kann vorgesehen sein, dass die Zeiterfassungsanordnung für die zeitliche Auswertung zur Ermittlung des Ladezustands zumindest die nachfolgenden Komponenten aufweist, welche insbesondere über elektrische Leitungen miteinander verschaltet sind, um die nachfolgend beschriebene Funktionalität auszuführen:
- eine Referenzeinheit zur Erzeugung einer Referenzspannung, vorzugsweise zur dynamischen Einstellung der Referenzspannung, bevorzugt bereitgestellt durch die Halteanordnung oder durch eine davon unabhängige Spannungsquelle,
- eine Vergleichseinheit, welche mit der Referenzeinheit und der Halteanordnung und/oder einer Messanordnung verschaltet ist, zum Vergleichen einer Auswertespannung mit der Referenzspannung, wobei die Auswertespannung und/oder Referenzspannung für eine elektrische Spannung und/oder für den Ladezustand an der Halteanordnung spezifisch ist,
- eine Initiierungseinheit, welche mit der Halteanordnung und/oder mit der Messanordnung verschaltet ist, zur Initiierung einer zeitlichen Veränderung der elektrischen Spannung und/oder der Auswertespannung, vorzugsweise eines Lade- oder Entladevorgangs bei der Halteanordnung oder bei der Messanordnung, sodass sich die Auswertespannung zeitlich während des Vergleichens verändert,
- eine Zeiteinheit, welche mit der Vergleichseinheit verschaltet ist, zur Ermittlung einer Zeitdauer von der Initiierung bis zum Erreichen (insbesondere Über- oder Unterschreiten) der Referenzspannung durch die Auswertespannung anhand des Vergleichens der Vergleichseinheit.

Damit kann zuverlässig anhand der ermittelten Zeitdauer der Ladezustand, und insbesondere eine zeitliche Veränderung des Ladezustands über mehrere Ladungsübertragungen, ausgewertet werden. Dies ermöglicht es, anhand der Veränderung des Ladezustands das Vorliegen einer Aktivierungshandlung zu detektieren. Um dabei stets eine hohe Sensitivität zu gewährleisten und ggf. eine Anpassung an die Umgebung zu ermöglichen, kann während des Betriebs optional auch eine dynamische Einstellung der Referenzspannung erfolgen. Es ist ebenfalls denkbar, dass die Messanordnung die Auswertespannung bereitstellt, und die Halteanordnung die Referenzspannung bereitstellt, oder alternativ die Halteanordnung die Auswertespannung bereitstellt.

Ferner ist es optional vorgesehen, dass die Halteanordnung wenigstens einen Haltekondensator aufweist, um anhand des Ladezustands als ein Ladezustand des Haltekondensators den Parameter zu ermitteln. Der Haltekondensator stellt dabei ein zuverlässiges elektrisches Mittel bereit, um die Ladung im Sensorelement aufzunehmen und anschließend zeitlich auswerten zu können.

Des Weiteren ist es im Rahmen der Erfindung optional möglich, dass die Zeiterfassungsanordnung dazu ausgeführt ist, eine vom Ladezustand abhängige Zeitdauer, vorzugsweise Entladezeitdauer oder Aufladezeitdauer, eines Haltekondensators der Halteanordnung zu erfassen, sodass diese erfasste Zeitdauer mit einer Ladung bzw. Ladungsmenge des Haltekondensators und/oder mit einer Sensorkapazität des Sensorelements korreliert. Auf diese Weise kann z. B. alle 20-30 ms eine Kapazitätsveränderung des Sensorelements (bzw. der Sensorkapazität) ermittelt werden. Da nunmehr nicht ein absoluter Spannungswert, sondern stattdessen eine Zeitdauer gemessen wird, kann zudem die Auflösung erhöht werden.

Zudem ist es im Rahmen der Erfindung denkbar, dass die Zeiterfassungsanordnung zur Erfassung einer vom Ladezustand abhängigen Zeitdauer einen (elektronischen) Komparator als Vergleichseinheit aufweist, um als die Zeitdauer eine Zeit zu messen bis eine Spannung eines Haltekondensators der Halteanordnung als Auswertespannung eine vorgegebene Spannungsschwelle als Referenzspannung erreicht, bevorzugt unter- oder überschreitet, wobei vorzugsweise die Zeitdauer abhängig ist von einer elektrischen Spannung des Haltekondensators unmittelbar nach der Ladungsübertragung. Es wird somit der gesamte Messvorgang durchgeführt, um einen einzigen Ladezustand der Halteanordnung zu erfassen.

Es ist ferner denkbar, dass die Zeiterfassungsanordnung zur Erfassung einer vom Ladezustand abhängigen Zeitdauer einen Komparator als Vergleichseinheit aufweist, um als die Zeitdauer eine Zeit zu messen bis eine Auswertespannung einer Messanordnung eine Spannungsschwelle gemäß einer Spannung eines Haltekondensators der Halteanordnung als Referenzspannung erreicht, bevorzugt unter- oder überschreitet, wobei vorzugsweise die Zeitdauer abhängig ist von einer elektrischen Spannung des Haltekondensators unmittelbar nach der Ladungsübertragung. Die Messanordnung kann hierzu z. B. einen Messkondensator aufweisen, welcher die Auswertespannung bereitstellt. Die Auswertespannung ist z. B. eine Spannung abhängig von der Spannung am Messkondensator. Die Auswertespannung kann durch einen Lade- oder Entladevorgang bei der Messanordnung zeitlich variiert werden. Hingegen kann die Spannung des Haltekondensators als Referenzspannung während der zeitlichen Auswertung unverändert bleiben. Dies bietet den Vorteil einer verbesserten Entkopplung der Halteanordnung zur Auswertung.

Es ist zudem denkbar, dass zur Auswertung kein absoluter Wert des Parameters des Sensorelements, sondern eine Veränderung des Parameters erfasst wird, um die Aktivierungshandlung festzustellen. Es kann also möglich sein, dass anhand des absoluten Wertes des Parameters (wie einer veränderlichen Sensorkapazität) und/oder anhand des absoluten Wertes des Ladezustands nicht die Aktivierungshandlung erkannt werden kann. Entscheidend kann vielmehr ein zeitlicher Verlauf dieser Größen sein. Dies macht es ggf. auch erforderlich, dass eine dynamische Nachregelung einer Referenzspannung erfolgt.

Ferner kann im Rahmen der Erfindung vorgesehen sein, dass die Kontrollvorrichtung eine Zwischenspeichervorrichtung zur Speicherung eines Ergebnisses der Auswertung und vorangegangener Auswertungen aufweist, um eine zeitliche Veränderung des Ladezustands und/oder des Parameters, insbesondere einer Sensorkapazität des Sensorelements, zu erfassen, um eine zeitliche Veränderung des Ladezustands der Halteanordnung und/oder des Parameters nach mehreren der Ladungsübertragungen für die Detektion auszuwerten. Hierzu können die Ergebnisse z. B. in digitaler Form in der Zwischenspeichervorrichtung als digitaler nicht-flüchtiger Datenspeicher abgelegt werden. Dies erfolgt über eine zuverlässigere Detektion z. B. einer Aktivierungshandlung.

Ferner ist es denkbar, dass eine Referenzeinheit, insbesondere ein Digital-Analog-Wandler, mit einer Vergleichseinheit zur zeitlichen Auswertung verschaltet ist, um dynamisch die Auswertung anzupassen, vorzugsweise eine Referenzspannung für die Auswertung nachzuregeln, insbesondere in Abhängigkeit von der zeitlichen Veränderung des Ladezustands nach mehreren der Ladungsübertragungen. Hierzu kann die Ansteuerungsvorrichtung z. B. die Ergebnisse auswerten, welche in einer Zwischenspeichervorrichtung gespeichert sind, und anhand dieser Auswertung die Nachregelung durchführen. Ein Vorteil der Nutzung der Referenzeinheit kann dabei auch sein, dass flexibel ein Referenzsignal erzeugt werden und hinsichtlich der Größe bestimmt werden kann, um die Auswertung anzupassen.

Des Weiteren kann vorgesehen sein, dass die Zeiterfassungsanordnung als Referenzeinheit einen Digital-Analog-Wandler aufweist, welcher eine Auflösung im Bereich von 2 Bit bis 64 Bit, vorzugsweise 4 Bit bis 16 Bit, bevorzugt 8 Bit bis 10 Bit aufweist. Somit ist eine technisch günstige Ausbildung der erfindungsgemäßen Anordnung möglich.

Gemäß einem weiteren Vorteil kann vorgesehen sein, dass die Zeiterfassungsanordnung eine Zeiteinheit, vorzugsweise einen elektronischen Timer, aufweist, um die zeitliche Auswertung durchzuführen. Der Timer ist somit ein Zeitgeber, um nach der Aktivierung der Zeiteinheit eine Zeitdauer zu messen (d. h. zu zählen), bis ein weiteres Ereignis eintritt. Das weitere Ereignis ist bspw. das Erreichen eines bestimmten Vergleichsergebnisses, wie das Erreichen eines Referenzsignals durch ein Auswertesignal.

Ebenfalls Gegenstand der Erfindung ist ein Verfahren für eine Detektion bei einem Türgriff eines Fahrzeuges, insbesondere zur Detektion einer Aktivierungshandlung beim Türgriff.

Vorteilhafterweise kann bei einem erfindungsgemäßen Verfahren zumindest einer der nachfolgenden Schritte durchgeführt werden, wobei die Schritte bevorzugt nacheinander in der angegebenen Reihenfolge oder in beliebiger Reihenfolge durchgeführt werden, und ggf. auch einzelne Schritte wiederholt werden können:
a) Durchführen einer Erfassung einer Veränderung in einer Umgebung eines Sensorelements, insbesondere durch das Sensorelement,
b) Durchführen einer wiederholten Ermittlung wenigstens eines für die Erfassung spezifischen Parameters des Sensorelements, um die Detektion bei dem Türgriff durchzuführen, insbesondere durch eine Kontroll- und/oder durch eine Ansteuerungsvorrichtung,
c) Durchführen einer wiederholten Ladungsübertragung zwischen dem wenigstens einen Sensorelement und einer elektrischen Halteanordnung, um anhand eines dadurch veränderten Ladezustands der Halteanordnung den Parameter zu ermitteln, insbesondere durch die Kontroll- und/oder Ansteuerungsvorrichtung,
d) Durchführen einer zeitlichen Auswertung der Halteanordnung zur Ermittlung des Ladezustands, insbesondere durch die Kontroll- und/oder Ansteuerungsvorrichtung und/oder durch eine Zeiterfassungsanordnung.

Damit bringt das erfindungsgemäße Verfahren die gleichen Vorteile mit sich, wie sie ausführlich mit Bezug auf eine erfindungsgemäße Anordnung beschrieben worden sind. Zudem können die Komponenten gemäß einer erfindungsgemäßen Anordnung ausgebildet sein.

Vorzugsweise kann dabei Schritt c) durchgeführt werden, um die jeweilige Ermittlung gemäß Schritt b) durchzuführen. In anderen Worten kann Schritt c) wiederholt durchgeführt werden, um die Detektion zu ermöglichen.

Von weiterem Vorteil kann vorgesehen sein, dass bei der zeitlichen Auswertung der Ladezustand der Halteanordnung, insbesondere nur, anhand einer Zeitmessung erfasst wird, vorzugsweise ohne die Verwendung einer Analog-Digital-Erfassung einer von dem Ladezustand der Halteanordnung abhängigen elektrischen Spannung. Somit kann der Vorteil erzielt werden, dass für die Schnelligkeit und Sensitivität der Erfassung keine Abhängigkeit von der Auflösung des Analog-Digital-Wandlers besteht.

Des Weiteren kann vorgesehen sein, dass die zeitliche Auswertung eine Auswertung einer zeitabhängigen Eigenschaft der Halteanordnung umfasst, vorzugsweise eine Auswertung einer Auf- und/oder Entladezeit der Halteanordnung. Somit kann ein Zeitgeber für die Schnelligkeit und Sensitivität der Erfassung entscheidend sein.

Ferner ist es denkbar, dass die zeitliche Auswertung zur Ermittlung des Ladezustands durch eine Ansteuerung einer Zeiterfassungsanordnung, vorzugsweise durch ein Aktivieren einer Zeiteinheit und/oder durch ein Aktivieren eines UND-Gatters, welches zwischen einer Vergleichseinheit und der Zeiteinheit verschaltet ist, zur Initiierung der Zeiterfassung erfolgt, wobei bevorzugt die Ansteuerung durch ein Schalten wenigstens einer Initiierungseinheit, besonders bevorzugt wenigstens einer der Schalteinheiten, zum Initiieren eines Lade- und/oder Entladevorgangs der Halteanordnung erfolgt. Somit ist eine zuverlässige Detektion möglich.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen jeweils schematisch:
- Figur 1: eine Seitenansicht auf ein Fahrzeug mit einer erfindungsgemäßen Anordnung,
- Figur 2: ein Schaltbild von Teilen einer erfindungsgemäßen Anordnung,
- Figur 3: ein weiteres Schaltbild von Teilen einer erfindungsgemäßen Anordnung,
- Figur 4: eine Entladekurve zur Visualisierung eines erfindungsgemäßen Verfahrens,
- Figur 5: ein weiteres Schaltbild von Teilen einer erfindungsgemäßen Anordnung.

In den nachfolgenden Figuren werden für die gleichen technischen Merkmale auch von unterschiedlichen Ausführungsbeispielen die identischen Bezugszeichen verwendet.

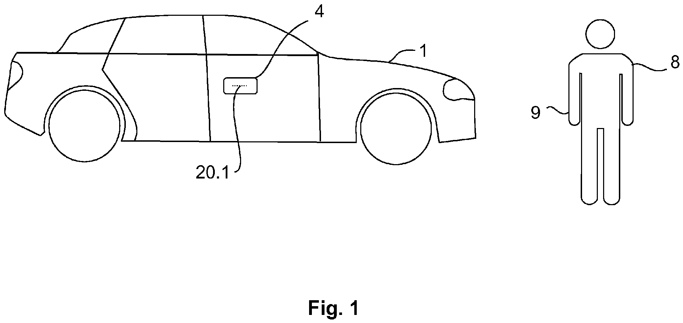

Figur 1 zeigt schematisch ein Fahrzeug 1 mit einem Türgriff 4, in dem eine erfindungsgemäße Anordnung 10, insbesondere Schaltanordnung 10, integriert ist. Als Teil der Anordnung 10 ist dabei wenigstens ein Sensorelement 20.1 gezeigt, welches zur Überwachung einer Umgebung des Türgriffs 4 dienen kann. So kann z. B. mittels der erfindungsgemäßen Anordnung 10 detektiert werden, wenn ein Benutzer 8 durch ein Aktivierungsmittel 9 wie ein Körperteil 9 (z. B. eine Hand) des Benutzers 8 die Umgebung des Türgriffs 4 beeinflusst. Hierzu kann eine Veränderung einer veränderlichen Sensorkapazität CS einer Sensorvorrichtung 20 gebildet und durch das Sensorelement 20.1 ausgewertet werden.

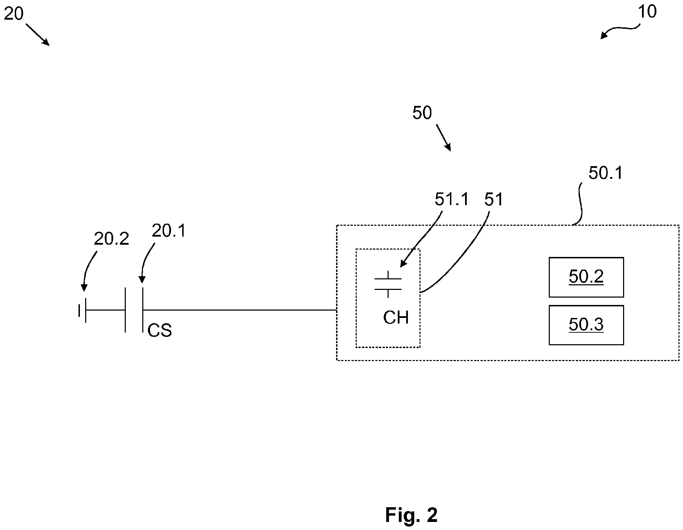

In Figur 2 ist die erfindungsgemäße Anordnung 10 für eine Detektion bei dem Türgriff 4 des Fahrzeuges 1 mit weiteren Einzelheiten gezeigt. Dabei kann das wenigstens eine Sensorelement 20.1 der Anordnung 10 eine Sensorkapazität CS gegenüber einem Massepotential 20.2 ausbilden, um eine Erfassung einer Veränderung in der Umgebung des Sensorelements 20.1 zu ermöglichen. Ferner kann eine Kontrollvorrichtung 50 zur wiederholten Ermittlung wenigstens eines für die Erfassung spezifischen Parameters des Sensorelements 20.1 vorgesehen sein, um die Detektion bei dem Türgriff 4 durchzuführen. Hierzu kann die Kontrollvorrichtung 50 eine Ansteuerungsvorrichtung 50.1 aufweisen, welche bspw. als Mikrocontroller oder dergleichen ausgebildet ist. Extern oder - wie in Figur 2 beispielhaft dargestellt ist - intern zur Ansteuerungsvorrichtung 50.1 kann eine Halteanordnung 51 mit einem Haltekondensator 51.1 zur Ausbildung einer Haltekapazität CH vorgesehen sein. Diese ist zur wiederholten Ladungsübertragung mit dem wenigstens einen Sensorelement 20.1 verschaltet, um anhand eines dadurch veränderten Ladezustands, insbesondere einer Ladezustandsveränderung, der Halteanordnung 51 den Parameter zu ermitteln. Ferner kann noch eine Verarbeitungseinheit 50.2 vorgesehen sein, welche z. B. als Prozessor zur Durchführung der Auswertung ausgeführt ist. Ebenfalls denkbar ist es, dass eine Zwischenspeichervorrichtung 50.3 als Datenspeicher genutzt wird, um Ergebnisse der Auswertung für eine bestimmte Zeit gespeichert zu halten.

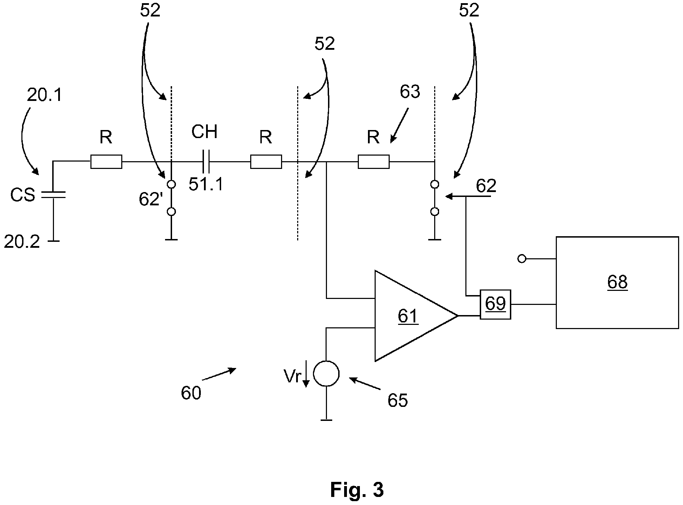

Gemäß Figur 3 kann außerdem eine Zeiterfassungsanordnung 60 der Kontrollvorrichtung 50 mit der Halteanordnung 51 verschaltet sein, um zur Ermittlung des (jeweils nach der Ladungsübertragung vorliegenden jeweils einzelnen) Ladezustands die Halteanordnung 51 zeitlich auszuwerten. Konkret dargestellt ist dabei die Verschaltung mit einem Haltekondensator 51.1 der Halteanordnung 51, welche die elektrische Haltekapazität CH bereitstellt. Die Zeiterfassungsanordnung 60 kann dabei zur zeitlichen Auswertung zumindest die nachfolgenden Komponenten aufweisen:
- eine Referenzeinheit 65 zur Erzeugung eines Referenzsignals Vr, insbesondere einer Referenzspannung Vr,
- eine Vergleichseinheit 61 zum Vergleich eines Auswertesignals, insbesondere einer elektrischen Auswertespannung, mit dem Referenzsignal Vr, insbesondere der Referenzspannung Vr, wobei das Auswertesignal, insbesondere die Auswertespannung, für den jeweils nach der Ladungsübertragung vorliegenden Ladezustand der Halteanordnung 51 spezifisch ist, und insbesondere für eine jeweils dann vorliegende elektrische Spannung an der Halteanordnung 51, bevorzugt an dem Haltekondensator 51.1, spezifisch ist,
- eine Zeiteinheit 68, insbesondere integriert in die Ansteuerungsvorrichtung 50.1, zur Ermittlung einer Zeitdauer in Abhängigkeit von dem Vergleich.

Die Ansteuerungsvorrichtung 50.1 (als Verarbeitungsvorrichtung 50.1) kann zum Auslesen der Zeitdauer von der Zeiteinheit 68 ausgeführt sein, um die Detektion bei dem Türgriff 4 anhand der Zeitdauer durchzuführen. Zur Aktivierung der Zeiteinheit 68 kann - wie dargestellt - eine elektrische Signalverbindung der Zeiteinheit 68 über ein UND-Gatter 69 zum Ausgang der Vergleichseinheit 61 vorgesehen sein. Wenn die Vergleichseinheit 61 somit eine Übereinstimmung des Auswertesignals und des Referenzsignals Vr feststellt, wird dies der Zeiteinheit 68 mitgeteilt und diese stoppt bspw. die gemessene Zeit.

Beispielhaft können mehrere Schalteinheiten 52 vorgesehen sein, welche teilweise mit den entsprechenden Stromzweigen der Schalteinheiten 52 über gestrichelte Linien nur angedeutet sind. Die Schalteinheiten 52 können für die jeweilige Ermittlung des Parameters eine elektrische Aufladung des Sensorelements 20.1 ermöglichen, um dann eine der wiederholten Ladungsübertragungen zur Halteanordnung 51, insbesondere durch ein Schalten wenigstens einer der Schalteinheiten 52, durchzuführen, um anschließend die zeitliche Auswertung zur Ermittlung des nach der Ladungsübertragung vorliegenden Ladezustands der Halteanordnung 51 zu initiieren.

Für die Auswertung kann die Referenzeinheit 65 als Digital-Analog-Wandler 65 zur Erzeugung der Referenzspannung Vr und vorzugsweise zur dynamischen Einstellung der Referenzspannung Vr genutzt werden. Hierzu ist die Referenzeinheit 65 z. B. mit der Ansteuerungsvorrichtung 50.1 verbunden oder darin integriert, um durch eine Verarbeitungseinheit 50.2 der Ansteuerungsvorrichtung 50.1 angesteuert zu werden. Die Vergleichseinheit 61 kann als Komparator 61 ausgebildet sein und mit der Referenzeinheit 65 und der Halteanordnung 51 verschaltet sein, um ein Vergleichen der Auswertespannung mit der Referenzspannung Vr durchzuführen. Ferner kann eine Initiierungseinheit 62 und ggf. eine weitere Initiierungseinheit 62' jeweils als Schalteinheit 52 ausgebildet sein, welche mit der Halteanordnung 51 verschaltet sind, um eine zeitliche Veränderung einer elektrischen Spannung am Haltekondensator 51.1 zu bewirken. Diese zeitliche Veränderung ist vorzugsweise ein Lade- oder Entladevorgang bei der Halteanordnung 51, sodass sich die Auswertespannung zeitlich während des Vergleichens verändert.

Die Zeiteinheit 68 ist bspw. als Timer ausgebildet und kann mit der Vergleichseinheit 61 verschaltet sein, um die Ermittlung einer Zeitdauer von der Initiierung bis zum Erreichen der Referenzspannung durch die Auswertespannung anhand des Vergleichens der Vergleichseinheit 61 durchzuführen.

Für die zeitliche Auswertung zur Ermittlung des Ladezustands kann eine Ansteuerung der Zeiterfassungsanordnung 60 erfolgen durch ein Aktivieren der Zeiteinheit 68 und/oder durch ein Aktivieren des UND-Gatters 69, welches zwischen der Vergleichseinheit 61 und der Zeiteinheit 68 verschaltet ist. Dies kann ein Initiieren der Zeiterfassung bewirken, wobei die Ansteuerung bevorzugt durch ein Schalten der wenigstens einen Initiierungseinheit 62, 62', besonders bevorzugt wenigstens einer der Schalteinheiten 52, zum Initiieren eines Lade- und/oder Entladevorgangs der Halteanordnung 51 erfolgt.

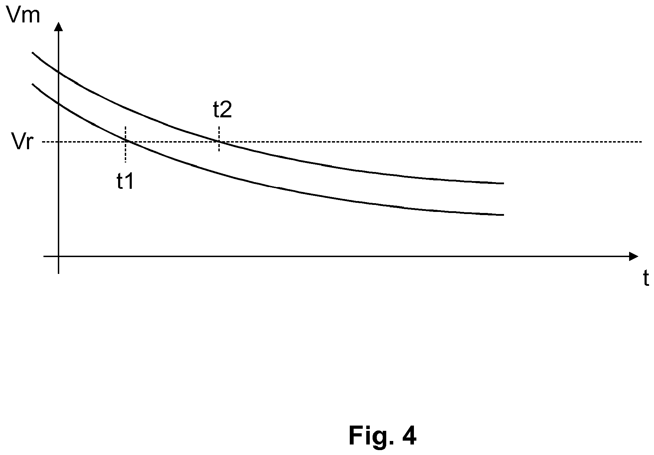

Gemäß Figur 4 werden beispielhaft zwei derartige zeitliche Veränderung, insbesondere Entladevorgänge des Haltekondensators 51.1, durch die Darstellung jeweiliger Messspannungen Vm über die Zeit t näher beschrieben. Das Auswertesignal ist dabei die Messspannung Vm, welche für einen Ladezustand bei dem Haltekondensator 51.1 spezifisch ist. Diese kann z. B. an einer Widerstandseinheit 63 durch die Vergleichseinheit 61 ermittelt werden. Nach der Initiierung des Entladevorgangs kann dabei ein Abfall der Messspannung Vm beobachtet werden, wobei das Erreichen der Referenzspannung Vr vom anfänglichen Ladezustand abhängig ist. Bei einem höheren Ladezustand wird die Referenzspannung Vr später erreicht (nach einer zweiten Zeitdauer t2) als bei einem niedrigeren Ladezustand nach der erste Zeitdauer t1. Anhand der Zeitdauern t1, t2 kann somit der jeweilige Ladezustand durch die zeitliche Auswertung ermittelt werden. Dabei kann nur durch eine Zeitmessung die Ermittlung des Ladezustands ermöglicht werden. In anderen Worten kann bei der zeitlichen Auswertung der Ladezustand der Halteanordnung 51, insbesondere nur, anhand einer Zeitmessung erfasst werden, vorzugsweise ohne die Verwendung einer Analog-Digital-Erfassung einer von dem Ladezustand der Halteanordnung 51 abhängigen elektrischen Spannung.

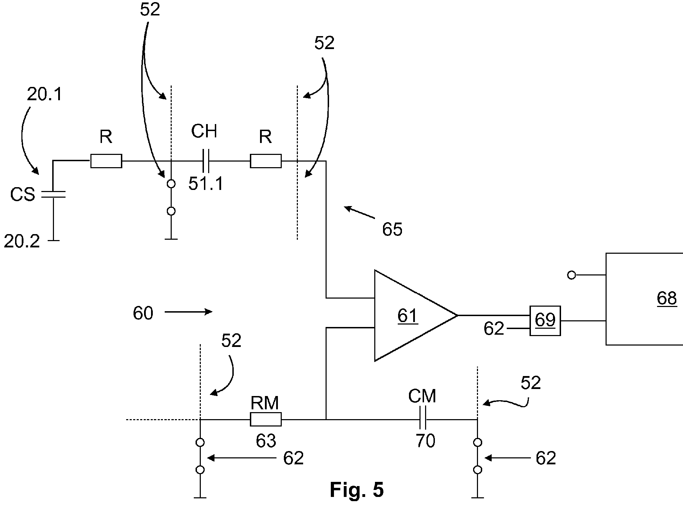

In Figur 5 ist eine weitere Variante der zeitlichen Auswertung der Halteanordnung 51 gezeigt. Für die Auswertung kann die Halteanordnung 51 mit dem Haltekondensator 51.1 eine Referenzspannung bereitstellen, und somit die Referenzeinheit 65 bilden. Wenn der Haltekondensator 51.1 nach einer oder mehreren Ladungsübertragungen von oder zum Sensorelement 20.1 einen bestimmten Ladezustand aufweist, wird dieser gehalten und stellt die Referenzspannung für den Komparator 61 bereit. Diese Referenzspannung ist abhängig vom Ladezustand des Sensorelements 20.1 vor den Ladungsübertragungen. Anschließend kann eine Messanordnung 70, insbesondere ein Messkondensator 70 mit einer Messkapazität CM, und einer Messwiderstandseinheit 63 als Messwiderstand RM genutzt werden, um die zeitliche Auswertung durchzuführen. Hierzu wird durch eine weitere Kontrollverschaltung (durch eine gestrichelte Linie repräsentiert) eine kontrollierte Lade- oder Entladung der Messanordnung 70 durchgeführt, um eine Auswertespannung zeitlich zu erhöhen oder zu verringern. Dieser Lade- oder Entladevorgang kann entsprechend dem Lade- oder Entladevorgang bei der Halteanordnung 51 im Ausführungsbeispiel gemäß Figur 3 ausgeführt sein. Anders als bei diesem Ausführungsbeispiel wird hier jedoch die Halteanordnung 51 zur Bereitstellung der Referenzspannung genutzt. Die zeitliche Dauer bis zum Erreichen der Referenzspannung durch die Spannung bei der Messanordnung 70 kann auf diese Weise durch die Zeiteinheit 68 gemessen werden und somit der Ladezustand des Sensorelements 20.1 bzw. des Haltekondensators 51.1 durch die zeitliche Auswertung ermittelt werden.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung gemäß den angehängten Merkmalen zu verlassen.

### Bezuaszeichenliste

- 1: Fahrzeug
- 4: Türgriff
- 8: Benutzer
- 9: Körperteil, Aktivierungsmittel

- 10: Anordnung, Schaltanordnung

- 20: Sensorvorrichtung
- 20.1: Sensorelement, Sensorelektrode
- 20.2: Massepotential

- 50: Kontrollvorrichtung
- 50.1: Ansteuerungsvorrichtung, Verarbeitungsvorrichtung, Mikrocontroller
- 50.2: Verarbeitungseinheit
- 50.3: Zwischenspeichervorrichtung
- 51: Halteanordnung
- 51.1: Haltekondensator
- 52: Schalteinheit

- 60: Zeiterfassungsanordnung
- 61: Vergleichseinheit, Komparator
- 62: Initiierungseinheit, Schaltereinheit
- 63: Widerstandseinheit, Entladewiderstand, Messwiderstandseinheit
- 65: Referenzeinheit, Digital-Analog-Wandler
- 68: Zeiteinheit, Zeitgebereinheit, Timer
- 69: UND-Gatter
- 70: Messkondensator
- 62': weitere Initiierungseinheit bzw. Schalteinheit
- t: Zeit
- t1: erste Zeitdauer
- t2: zweite Zeitdauer
- CH: Haltekapazität
- CS: Sensorkapazität
- Vm: Messspannung
- Vr: Referenzspannung
- RM: Messwiderstand
- CM: Messkondensator

## Patentansprüche

1. Anordnung (10) für eine Detektion bei einem Türgriff (4) eines Fahrzeuges (1), insbesondere zur Detektion einer Aktivierungshandlung beim Türgriff (4), aufweisend:
- wenigstens ein Sensorelement (20.1) zur Erfassung einer Veränderung in einer Umgebung des Sensorelements (20.1),
- eine Kontrollvorrichtung (50) zur wiederholten Ermittlung wenigstens eines für die Erfassung spezifischen Parameters des Sensorelements (20.1), um die Detektion bei dem Türgriff (4) durchzuführen,
- eine elektrische Halteanordnung (51), welche zur wiederholten Ladungsübertragung mit dem wenigstens einen Sensorelement (20.1) verschaltet ist, um anhand eines dadurch veränderten Ladezustands der Halteanordnung (51) den Parameter zu ermitteln,
wobei eine Zeiterfassungsanordnung (60) der Kontrollvorrichtung (50) mit der Halteanordnung (51) verschaltet ist, um zur Ermittlung des Ladezustands die Halteanordnung (51) zeitlich auszuwerten, wobei
die Zeiterfassungsanordnung (60) zur zeitlichen Auswertung zumindest die nachfolgenden Komponenten aufweist:
- eine Referenzeinheit (65) zur Erzeugung eines Referenzsignals,
- eine Vergleichseinheit (61) zum Vergleich eines Auswertesignals mit dem Referenzsignal, wobei das Auswertesignal und/oder das Referenzsignal für den jeweils nach der Ladungsübertragung vorliegenden Ladezustand der Halteanordnung (51) spezifisch ist,
- eine Zeiteinheit (68) zur Ermittlung einer Zeitdauer in Abhängigkeit von dem Vergleich'**dadurch gekennzeichnet, dass** die Zeiterfassungsanordnung (60) zur Erfassung einer Entladezeitdauer eines Haltekondensators (51.1) der Halteanordnung (51) oder eines Messkondensators (70) in Abhängigkeit von dem Haltekondensator (51.1) ausgeführt ist, um hierdurch die Halteanordnung (51) zeitlich auszuwerten.

2. Anordnung (10) nach Anspruch 1,
**dadurch gekennzeichnet,**
**dass** eine Verarbeitungsvorrichtung (50.1) vorgesehen und zum Auslesen der Zeitdauer von der Zeiteinheit (68) ausgeführt ist, um die Detektion bei dem Türgriff (4) anhand der Zeitdauer durchzuführen.

3. Anordnung (10) nach Anspruch 1 oder 2,
**dadurch gekennzeichnet,**
**dass** die Zeiterfassungsanordnung (60) dazu ausgeführt ist, den Ladezustand durch die zeitliche Auswertung dadurch zu ermitteln, dass ein Messvorgang zur Ermittlung des Ladezustands initiiert und zeitlich ausgewertet wird.

4. Anordnung (10) nach einem der vorhergehenden Ansprüche,
**dadurch gekennzeichnet,**
**dass** eine Ansteuerungsvorrichtung (50.1) vorgesehen ist, welche insbesondere zum Schalten mehrerer Schalteinheiten (52) ausgeführt ist, um für die jeweilige Ermittlung des Parameters zumindest nachfolgendes zu initiieren:
- eine elektrische Aufladung des Sensorelements (20.1),
- eine der wiederholten Ladungsübertragungen zur Halteanordnung (51), insbesondere durch ein Schalten wenigstens einer der Schalteinheiten (52),
- die zeitliche Auswertung zur Ermittlung des nach der Ladungsübertragung vorliegenden Ladezustands der Halteanordnung (51), vorzugweise zumindest teilweise gleichzeitig mit einer Auf- oder Entladung der Halteanordnung (51),
- eine erneute elektrische Aufladung des Sensorelements (20.1).

5. Anordnung (10) nach einem der vorhergehenden Ansprüche,
**dadurch gekennzeichnet,**
**dass** die Zeiterfassungsanordnung (60) für die zeitliche Auswertung zur Ermittlung des Ladezustands zumindest die nachfolgenden Komponenten aufweist:
- eine Referenzeinheit (65) zur Erzeugung einer Referenzspannung, vorzugsweise zur dynamischen Einstellung der Referenzspannung, bevorzugt bereitgestellt durch die Halteanordnung (51),
- eine Vergleichseinheit (61), welche mit der Referenzeinheit (65) und der Halteanordnung (51) und/oder einer Messanordnung (70) verschaltet ist, zum Vergleichen einer Auswertespannung mit der Referenzspannung, wobei die Auswertespannung und/oder Referenzspannung für eine elektrische Spannung an der Halteanordnung (51) spezifisch ist,
- eine Initiierungseinheit (62), welche mit der Halteanordnung (51) und/oder mit der Messanordnung (70) verschaltet ist, zur Initiierung einer zeitlichen Veränderung der elektrischen Spannung und/oder Auswertespannung, vorzugsweise eines Lade- oder Entladevorgangs bei der Halteanordnung (51), sodass sich die Auswertespannung zeitlich während des Vergleichens verändert,
- eine Zeiteinheit (68), welche mit der Vergleichseinheit (61) verschaltet ist, zur Ermittlung einer Zeitdauer von der Initiierung bis zum Erreichen der Referenzspannung durch die Auswertespannung anhand des Vergleichens der Vergleichseinheit (61).

6. Anordnung (10) nach einem der vorhergehenden Ansprüche,
**dadurch gekennzeichnet,**
**dass** die Halteanordnung (51) wenigstens einen Haltekondensator (51.1) aufweist, um anhand des Ladezustands als ein Ladezustand des Haltekondensators (51.1) den Parameter zu ermitteln.

7. Anordnung (10) nach einem der vorhergehenden Ansprüche,
**dadurch gekennzeichnet,**
**dass** die Zeiterfassungsanordnung (60) dazu ausgeführt ist, eine vom Ladezustand abhängige Zeitdauer, vorzugsweise Entladezeitdauer oder Aufladezeitdauer eines Haltekondensators (51.1) der Halteanordnung (51), zu erfassen, sodass diese erfasste Zeitdauer mit einer Ladung des Haltekondensators (51.1) und/oder mit einer Sensorkapazität (CS) des Sensorelements (20.1) korreliert,
und/oder dass die Zeiterfassungsanordnung (60) zur Erfassung einer vom Ladezustand abhängigen Zeitdauer einen Komparator (61) als Vergleichseinheit (61) aufweist, um als die Zeitdauer eine Zeit zu messen bis eine Spannung eines Haltekondensators (51.1) der Halteanordnung (51) als Auswertespannung eine vorgegebene Spannungsschwelle als Referenzspannung erreicht, bevorzugt unter- oder überschreitet, wobei vorzugsweise die Zeitdauer abhängig ist von einer elektrischen Spannung des Haltekondensators (51.1) unmittelbar nach der Ladungsübertragung,
und/oder dass die Zeiterfassungsanordnung (60) zur Erfassung einer vom Ladezustand abhängigen Zeitdauer einen Komparator (61) als Vergleichseinheit (61) aufweist, um als die Zeitdauer eine Zeit zu messen bis eine Auswertespannung einer Messanordnung (70) eine Spannungsschwelle gemäß einer Spannung eines Haltekondensators (51.1) der Halteanordnung (51) als Referenzspannung erreicht, bevorzugt unter- oder überschreitet, wobei vorzugsweise die Zeitdauer abhängig ist von einer elektrischen Spannung des Haltekondensators (51.1) unmittelbar nach der Ladungsübertragung.

8. Anordnung (10) nach einem der vorhergehenden Ansprüche,
**dadurch gekennzeichnet,**
**dass** die Kontrollvorrichtung (50) eine Zwischenspeichervorrichtung (50.3) zur Speicherung eines Ergebnisses der Auswertung und vorangegangener Auswertungen aufweist, um eine zeitliche Veränderung des Ladezustands und/oder des Parameters, insbesondere einer Sensorkapazität (CS) des Sensorelements (20.1), zu erfassen, um eine zeitliche Veränderung des Ladezustands der Halteanordnung (51) nach mehreren der Ladungsübertragungen für die Detektion auszuwerten.

9. Anordnung (10) nach einem der vorhergehenden Ansprüche,
**dadurch gekennzeichnet,**
**dass** eine Referenzeinheit (65), insbesondere ein Digital-Analog-Wandler (65), mit einer Vergleichseinheit (61) zur zeitlichen Auswertung verschaltet ist, um dynamisch die Auswertung anzupassen, vorzugsweise eine Referenzspannung für die Auswertung nachzuregeln, insbesondere in Abhängigkeit von der zeitlichen Veränderung des Ladezustands nach mehreren der Ladungsübertragungen.

10. Anordnung (10) nach einem der vorhergehenden Ansprüche,
**dadurch gekennzeichnet,**
**dass** die Zeiterfassungsanordnung (60) als Referenzeinheit (65) einen Digital-Analog-Wandler (65) aufweist, welcher eine Auflösung im Bereich von 2 Bit bis 64 Bit, vorzugsweise 4 Bit bis 16 Bit, bevorzugt 8 Bit bis 10 Bit aufweist,
und/oder dass die Zeiterfassungsanordnung (60) eine Zeiteinheit (68), vorzugsweise einen elektronischen Timer, aufweist, um die zeitliche Auswertung durchzuführen.

11. Verfahren für eine Detektion bei einem Türgriff (4) eines Fahrzeuges (1), insbesondere zur Detektion einer Aktivierungshandlung beim Türgriff (4),
wobei die nachfolgenden Schritte durchgeführt werden:
a) Durchführen einer Erfassung einer Veränderung in einer Umgebung eines Sensorelements (20.1),
b) Durchführen einer wiederholten Ermittlung wenigstens eines für die Erfassung spezifischen Parameters des Sensorelements (20.1), um die Detektion bei dem Türgriff (4) durchzuführen,
c) Durchführen einer wiederholten Ladungsübertragung zwischen dem wenigstens einen Sensorelement (20.1) und einer elektrischen Halteanordnung (51), um anhand eines dadurch veränderten Ladezustands der Halteanordnung (51) den Parameter zu ermitteln,
d) Durchführen einer zeitlichen Auswertung der Halteanordnung (51) zur Ermittlung des Ladezustands, wobei
bei der zeitlichen Auswertung der Ladezustand der Halteanordnung (51) anhand einer Zeitmessung erfasst wird, vorzugsweise ohne die Verwendung einer Analog-Digital-Erfassung einer von dem Ladezustand der Halteanordnung (51) abhängigen elektrischen Spannung,
**dadurch gekennzeichnet, dass** die zeitliche Auswertung eine Auswertung einer Entladezeit der Halteanordnung (51) umfasst.

12. Verfahren nach Anspruch 11,
**dadurch gekennzeichnet,**
**dass** die zeitliche Auswertung eine Auswertung einer Auf- und Entladezeit der Halteanordnung (51).

13. Verfahren nach einem der Ansprüche 11 oder 12,
**dadurch gekennzeichnet,**
**dass** die zeitliche Auswertung zur Ermittlung des Ladezustands durch eine Ansteuerung einer Zeiterfassungsanordnung (60), vorzugsweise durch ein Aktivieren einer Zeiteinheit (68) und/oder durch ein Aktivieren eines UND-Gatters (69), welches zwischen einer Vergleichseinheit (61) und der Zeiteinheit (68) verschaltet ist, zur Initiierung der Zeiterfassung erfolgt, wobei die Ansteuerung bevorzugt durch ein Schalten wenigstens einer Initiierungseinheit (62), besonders bevorzugt wenigstens einer der Schalteinheiten (52), zum Initiieren eines Lade- und/oder Entladevorgangs der Halteanordnung (51) erfolgt.

14. Verfahren nach einem der Ansprüche 11 bis 13,
**dadurch gekennzeichnet,**
**dass** durch das Verfahren ein Betreiben einer Anordnung (10) nach einem der Ansprüche 1 bis 10 durchgeführt wird.

## Claims

1. Arrangement (10) for detection at a door handle (4) of a vehicle (1), in particular for detecting an activation action at the door handle (4):
- at least one sensor element (20.1) for detecting a change in an environment of the sensor element (20.1),
- a control device (50) for repeatedly determining at least one parameter of the sensor element (20.1) specific to the detection in order to perform the detection on the door handle (4),
- an electrical holding arrangement (51) which is connected to the at least one sensor element (20.1) for repeated charge transfer in order to determine the parameteron the basis of a thereby changed state of charge of the holding arrangement (51),
wherein a time recording arrangement (60) of the control device (50) is connected to the holding arrangement (51) in order to evaluate the holding arrangement (51) in terms of time in order to determine the state of charge, wherein
the time recording arrangement (60) has at least the following components for time evaluation:
- a reference unit (65) for generating a reference signal,
- a comparison unit (61) for comparing an evaluation signal with the reference signal, the evaluation signal and/or the reference signal being specific to the state of charge of the holding arrangement (51) present in each case after the charge transfer,
- a time unit (68) for determining a time duration as a function of the comparison,
**characterized in that**
the time recording arrangement (60) is designed to detect a discharge time duration of a holding capacitor (51.1) of the holding arrangement (51) or of a measuring capacitor (70) as a function of the holding capacitor (51.1), in order to thereby evaluate the holding arrangement (51) in terms of time.

2. Arrangement (10) according to claim 1,
**characterized in that**
a processing device (50.1) is provided and designed to read out the time duration from the time unit (68) in order to carry out the detection at the door handle (4) on the basis of the time duration.

3. Arrangement (10) according to claim 1 or 2,
**characterized in that**
the time recording arrangement (60) is designed to determine the state of charge by the time evaluation **in that** a measurement process for determining the state of charge is initiated and evaluated in terms of time.

4. Arrangement (10) according to one of the preceding claims,
**characterized in that**
an actuating device (50.1) is provided, which is designed in particular for switching a plurality of switching units (52) in order to initiate at least the following for the respective determination of the parameter:
- an electrical charge of the sensor element (20.1),
- one of the repeated charge transfers to the holding arrangement (51), in particular by switching at least one of the switching units (52),
- the time evaluation for determining the state of charge of the holding arrangement (51) after the charge transfer, preferably at least partially simultaneously with a charging or discharging of the holding arrangement (51),
- a renewed electrical charging of the sensor element (20.1).

5. Arrangement (10) according to one of the preceding claims,
**characterized in that**
the time recording arrangement (60) for the time evaluation for determining the state of charge has at least the following components:
- a reference unit (65) for generating a reference voltage, preferably for dynamic adjustment of the reference voltage, preferably provided by the holding arrangement (51),
- a comparison unit (61), which is connected to the reference unit (65) and the holding arrangement (51) and/or a measuring arrangement (70), for comparing an evaluation voltage with the reference voltage, the evaluation voltage and/or reference voltage being specific for an electrical voltage at the holding arrangement (51),
- an initiation unit (62), which is connected to the holding arrangement (51) and/or to the measuring arrangement (70), for initiating a temporal change in the electrical voltage and/or evaluation voltage, preferably a charging or discharging process in the holding arrangement (51), so that the evaluation voltage changes in time during the comparison,
- a time unit (68), which is connected to the comparison unit (61), for determining a time duration from the initiation until the reference voltage is reached by the evaluation voltage on the basis of the comparison of the comparison unit (61).

6. Arrangement (10) according to one of the preceding claims,
**characterized in that**
the holding arrangement (51) has at least one holding capacitor (51.1) in order to determine the parameter on the basis of the state of charge as a state of charge of the holding capacitor (51.1).

7. Arrangement (10) according to one of the preceding claims,
**characterized in that**
the time recording arrangement (60) is designed to detect a time duration dependent on the state of charge, preferably a discharge time duration or charge time duration of a holding capacitor (51.1) of the holding arrangement (51), so that this detected time duration correlates with a charge of the holding capacitor (51.1) and/or with a sensor capacitance (CS) of the sensor element (20.1),
and/or **in that** the time recording arrangement (60) has a comparator (61) as a comparison unit (61) for recording a time duration dependent on the state of charge, in order to measure as the time duration a time until a voltage of a holding capacitor (51.1) of the holding arrangement (51) reaches, preferably falls below or exceeds, a predetermined voltage threshold as a reference voltage as an evaluation voltage, the time duration preferably being dependent on an electrical voltage of the holding capacitor (51.1) immediately after the charge transfer,
and/or **in that** the time recording arrangement (60) has a comparator (61) as a comparison unit (61) for recording a time duration dependent on the state of charge, in order to measure, as the time duration, a time until an evaluation voltage of a measuring arrangement (70) reaches, preferably falls below or exceeds, a voltage threshold in accordance with a voltage of a holding capacitor (51.1) of the holding arrangement (51) as reference voltage, the time duration preferably being dependent on an electrical voltage of the holding capacitor (51.1) immediately after the charge transfer.

8. Arrangement (10) according to one of the preceding claims,
**characterized in that**
the control device (50) has an intermediate storage device (50.3) for storing a result of the evaluation and previous evaluations in order to detect a temporal change in the state of charge and/or the parameter, in particular a sensor capacitance (CS) of the sensor element (20.1), in order to evaluate a temporal change in the state of charge of the holding arrangement (51) after a plurality of the charge transfers for the detection.

9. Arrangement (10) according to one of the preceding claims,
**characterized in that**
a reference unit (65), in particular a digital-to-analog converter (65), is connected to a comparison unit (61) for temporal evaluation in order to dynamically adapt the evaluation, preferably to readjust a reference voltage for the evaluation, in particular as a function of the temporal change in the state of charge after a plurality of the charge transfers.

10. Arrangement (10) according to one of the preceding claims,
**characterized in that**
the time recording arrangement (60) has a digital-to-analog converter (65) as reference unit (65), which has a resolution in the range from 2 bits to 64 bits, preferably 4 bits to 16 bits, preferably 8 bits to 10 bits,
and/or **in that** the time recording arrangement (60) has a time unit (68), preferably an electronic timer, in order to carry out the time evaluation.

11. Method for detecting a door handle (4) of a vehicle (1), in particular for detecting an activation action at the door handle (4),
whereby the following steps are carried out:
a) Performing a detection of a change in an environment of a sensor element (20.1),
b) Performing a repeated determination of at least one parameter of the sensor element (20.1) specific to the detection in order to perform the detection on the door handle (4),
c) carrying out a repeated charge transfer between the at least one sensor element (20.1) and an electrical holding arrangement (51) in order to determine the parameter on the basis of a resulting change in the state of charge of the holding arrangement (51),
d) carrying out a temporal evaluation of the holding arrangement (51) to determine the state of charge, wherein
during the time evaluation, the charge state of the holding arrangement (51) is detected by means of a time measurement, preferably without the use of analog-digital detection of an electrical voltage dependent on the charge state of the holding arrangement (51),
**characterized in that**
the time evaluation comprises an evaluation of a discharge time of the holding arrangement (51).

12. Method according to claim 11,
**characterized in that**
the time evaluation is an evaluation of a charging and discharging time of the holding arrangement (51).

13. Method according to any one of claims 11 or 12,
**characterized in that**
the time evaluation for determining the state of charge is carried out by activating a time recording arrangement (60), preferably by activating a time unit (68) and/or by activating an AND gate (69), which is connected between a comparison unit (61) and the time unit (68), for initiating the time detection, the activation preferably taking place by switching at least one initiation unit (62), particularly preferably at least one of the switching units (52), for initiating a charging and/or discharging process of the holding arrangement (51).

14. Method according to any one of claims 11 to 13,
**characterized in that**
by the method an operation of an arrangement (10) according to any one of claims 1 to 10 is carried out.

## Revendications

1. Agencement (10) pour une détection au niveau d'une poignée de porte (4) d'un véhicule (1), présentant en particulier pour la détection d'une action d'activation au niveau de la poignée de porte (4) :
- au moins un élément de détection (20.1) pour détecter une modification dans un environnement de l'élément de détection (20.1),
- un dispositif de contrôle (50) pour déterminer de manière répétée au moins un paramètre de l'élément de détection (20.1) spécifique à la détection, afin d'effectuer la détection sur la poignée de porte (4),
- un dispositif de maintien électrique (51), qui est connecté à l'au moins un élément de détection (20.1) pour un transfert de charge répété, afin de déterminer le paramètre à l'aide d'un état de charge ainsi modifié du dispositif de maintien (51),
dans lequel un dispositif d'enregistrement temporel (60) du dispositif de contrôle (50) est connecté au dispositif de maintien (51) afin d'évaluer temporellement le dispositif de maintien (51) pour déterminer l'état de charge, dans lequel
le dispositif d'enregistrement temporel (60) présente au moins les composants suivants pour l'évaluation temporelle :
- une unité de référence (65) pour générer un signal de référence,
- une unité de comparaison (61) pour comparer un signal d'évaluation avec le signal de référence, le signal d'évaluation et/ou le signal de référence étant spécifique à l'état de charge du dispositif de maintien (51) présent respectivement après le transfert de charge,
- une unité de temps (68) pour déterminer une durée en fonction de la comparaison,
**caractérisé en ce que**
le dispositif d'enregistrement temporel (60) est réalisé pour détecter une durée de décharge d'un condensateur de maintien (51.1) du dispositif de maintien (51) ou d'un condensateur de mesure (70) en fonction du condensateur de maintien (51.1), afin d'évaluer ainsi le dispositif de maintien (51) dans le temps.

2. Agencement (10) selon la revendication 1,
**caractérisé en ce qu'**
un dispositif de traitement (50.1) est prévu et réalisé pour lire la durée à partir de l'unité de temps (68), afin d'effectuer la détection au niveau de la poignée de porte (4) à l'aide de la durée.

3. Agencement (10) selon la revendication 1 ou 2,
**caractérisé en ce que**
le dispositif d'enregistrement temporel (60) est réalisé pour déterminer l'état de charge par l'évaluation temporelle en initiant un processus de mesure pour déterminer l'état de charge et en l'évaluant dans le temps.

4. Agencement (10) selon l'une quelconque des revendications précédentes,
**caractérisé en ce qu'**
il est prévu sur un dispositif de commande (50.1) qui est réalisé en particulier pour commuter plusieurs unités de commutation (52) afin d'initier au moins ce qui suit pour la détermination respective du paramètre :
- une charge électrique de l'élément de détection (20.1),
- l'un des transferts de charge répétés vers le dispositif de maintien (51), notamment par une commutation d'au moins l'une des unités de commutation (52),
- l'évaluation temporelle pour déterminer l'état de charge du dispositif de maintien (51) présent après le transfert de charge, de préférence au moins partiellement en même temps qu'une charge ou une décharge du dispositif de maintien (51),
- une nouvelle charge électrique de l'élément de détection (20.1).

5. Agencement (10) selon l'une quelconque des revendications précédentes,
**caractérisé en ce que**
le dispositif d'enregistrement temporel (60) présente au moins les composants suivants pour l'évaluation temporelle en vue de la détermination de l'état de charge :
- une unité de référence (65) pour générer une tension de référence, de préférence pour le réglage dynamique de la tension de référence, de préférence fournie par le dispositif de maintien (51),
- une unité de comparaison (61), qui est connectée à l'unité de référence (65) et au dispositif de maintien (51) et/ou à un dispositif de mesure (70), pour comparer une tension d'évaluation à la tension de référence, la tension d'évaluation et/ou la tension de référence étant spécifique à une tension électrique sur le dispositif de maintien (51),
- une unité d'initiation (62), qui est connectée au dispositif de maintien (51) et/ou au dispositif de mesure (70), pour initier une variation dans le temps de la tension électrique et/ou de la tension d'évaluation, de préférence une opération de charge ou de décharge dans le dispositif de maintien (51), de sorte que la tension d'évaluation varie dans le temps pendant la comparaison,
- une unité de temps (68), qui est connectée à l'unité de comparaison (61), pour déterminer une durée entre l'initiation et l'atteinte de la tension de référence par la tension d'évaluation sur la base de la comparaison de l'unité de comparaison (61).

6. Agencement (10) selon l'une quelconque des revendications précédentes,
**caractérisé en ce que**
le dispositif de maintien (51) présente au moins un condensateur de maintien (51.1) pour déterminer le paramètre à l'aide de l'état de charge comme un état de charge du condensateur de maintien (51.1).

7. Agencement (10) selon l'une quelconque des revendications précédentes,
**caractérisé en ce que**
le dispositif d'enregistrement temporel (60) est réalisé pour détecter une durée dépendant de l'état de charge, de préférence une durée de décharge ou une durée de charge d'un condensateur de maintien (51.1) du dispositif de maintien (51), de sorte que cette durée détectée est corrélée avec une charge du condensateur de maintien (51.1) et/ou avec une capacité de capteur (CS) de l'élément de détection (20.1),
et/ou **en ce que** le dispositif d'enregistrement temporel (60) présente, pour l'enregistrement d'une durée dépendant de l'état de charge, un comparateur (61) en tant qu'unité de comparaison (61), afin de mesurer, en tant que durée, un temps jusqu'à ce qu'une tension d'un condensateur de maintien (51.1) du dispositif de maintien (51) atteigne, en tant que tension d'évaluation, un seuil de tension prédéfini en tant que tension de référence, de préférence en dessous ou au-dessus de celui-ci, la durée dépendant de préférence d'une tension électrique du condensateur de maintien (51.1) immédiatement après le transfert de charge,
et/ou **en ce que** le dispositif d'enregistrement temporel (60) présente, pour l'enregistrement d'une durée dépendant de l'état de charge, un comparateur (61) en tant qu'unité de comparaison (61), afin de mesurer, en tant que durée, un temps jusqu'à ce qu'une tension d'évaluation d'un dispositif de mesure (70) atteigne, de préférence dépasse vers le bas ou vers le haut, un seuil de tension selon une tension d'un condensateur de maintien (51.1) du dispositif de maintien (51) en tant que tension de référence, la durée dépendant de préférence d'une tension électrique du condensateur de maintien (51.1) immédiatement après le transfert de charge.

8. Agencement (10) selon l'une quelconque des revendications précédentes,
**caractérisé en ce que**
le dispositif de contrôle (50) présente un dispositif de mémorisation intermédiaire (50.3) pour mémoriser un résultat de l'évaluation et des évaluations précédentes, pour détecter une variation dans le temps de l'état de charge et/ou du paramètre, en particulier d'une capacité de capteur (CS) de l'élément de détection (20.1), afin d'évaluer une variation dans le temps de l'état de charge du dispositif de maintien (51) après plusieurs des transferts de charge pour la détection.

9. Agencement (10) selon l'une quelconque des revendications précédentes,
**caractérisé en ce qu'**
une unité de référence (65), en particulier un convertisseur numérique-analogique (65), est connectée à une unité de comparaison (61) pour l'évaluation temporelle, afin d'adapter dynamiquement l'évaluation, de préférence de réajuster une tension de référence pour l'évaluation, en particulier en fonction de la variation temporelle de l'état de charge après plusieurs des transferts de charge.

10. Agencement (10) selon l'une quelconque des revendications précédentes,
**caractérisé en ce que**
le dispositif d'enregistrement temporel (60) présente comme unité de référence (65) un convertisseur numérique-analogique (65) qui présente une résolution dans la plage de 2 bits à 64 bits, de préférence de 4 bits à 16 bits, de préférence de 8 bits à 10 bits, et/ou **en ce que** le dispositif d'enregistrement temporel (60) présente une unité de temps (68), de préférence une minuterie électronique, pour effectuer l'évaluation temporelle.

11. Procédé pour une détection sur une poignée de porte (4) d'un véhicule (1), en particulier pour la détection d'une action d'activation sur la poignée de porte (4),
dans lequel les étapes suivantes sont effectues:
a) effectuer une détection d'un changement dans un environnement d'un élément de détection (20.1),
b) effectuer une détermination répétée d'au moins un paramètre de l'élément de détection (20.1) spécifique à la détection, afin d'effectuer la détection au niveau de la poignée de porte (4),
c) effectuer un transfert de charge répété entre le au moins un élément de détection (20.1) et un dispositif de maintien électrique (51), afin de déterminer le paramètre à l'aide d'un état de charge ainsi modifié du dispositif de maintien (51),
d) réalisation d'une évaluation temporelle du dispositif de maintien (51) pour déterminer l'état de charge, où
lors de l'évaluation temporelle, l'état de charge du dispositif de maintien (51) est détecté à l'aide d'une mesure du temps, de préférence sans l'utilisation d'une détection analogique-numérique d'une tension électrique dépendant de l'état de charge du dispositif de maintien (51),
**caractérisé en ce que**
l'évaluation temporelle comprend une évaluation d'un durée de décharge du dispositif de maintien (51).

12. Procédé selon la revendication 11,
**caractérisé en ce que**
l'évaluation temporelle est une évaluation d'un durée de chargement et de déchargement du dispositif de maintien (51).

13. Procédé selon l'une des revendications 11 ou 12,
**caractérisé en ce que**
l'évaluation temporelle pour déterminer l'état de charge par une commande d'un dispositif d'enregistrement temporel (60), de préférence par une activation d'une unité de temps (68) et/ou par une activation d'une porte ET (69), qui est connectée entre une unité de comparaison (61) et l'unité de temps (68), pour initier la saisie du temps, la commande s'effectuant de préférence par une commutation d'au moins une unité d'initiation (62), de préférence au moins une des unités de commutation (52), pour initier un processus de charge et/ou de décharge du dispositif de maintien (51).

14. Procédé selon l'une quelconque des revendications 11 à 13,
**caractérisé en ce que**
par le procédé, on effectue un fonctionnement d'un agencement (10) selon l'une des revendications 1 à 10.
